(19) Europäisches Patentamt
European Patent Office
Office européen des brevets

(11) **EP 3 082 000 B1**

(12) **EUROPÄISCHE PATENTSCHRIFT**

(45) Veröffentlichungstag und Bekanntmachung des Hinweises auf die Patenterteilung:
**10.06.2020  Patentblatt 2020/24**

(21) Anmeldenummer: **15163609.9**

(22) Anmeldetag: **15.04.2015**

(51) Int Cl.:
*G06F 30/15* (2020.01)   *G06F 30/20* (2020.01)
*G05B 17/02* (2006.01)   *G05B 19/042* (2006.01)

(54) **VERFAHREN UND SYSTEM ZUM TESTEN EINES MECHATRONISCHEN SYSTEMS**

METHOD AND SYSTEM FOR TESTING A MECHATRONIC SYSTEM

PROCÉDÉ ET SYSTÈME DE TEST D'UN SYSTÈME MÉCATRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.10.2016  Patentblatt 2016/42**

(73) Patentinhaber: **dSPACE digital signal processing and control engineering GmbH 33102 Paderborn (DE)**

(72) Erfinder: **Senf, Matthias 33100 Paderborn (DE)**

(56) Entgegenhaltungen:
**CN-U- 201 837 703      US-A- 6 167 545
US-A1- 2003 046 613    US-A1- 2004 044 973
US-A1- 2011 145 653**

**Beschreibung**

Die Erfindung betrifft ein computerimplementiertes Verfahren zum Testen eines realen und/oder virtuellen mechatronischen Automotive-Systems oder eines anderen realen und/oder virtuellen mechatronischen Systems durch einen Test mittels einer mit dem realen und/oder virtuellen mechatronischen System wechselwirkenden Testumgebung, wobei das Verfahren eine Testreihe mit unterschiedliche Testfällen (Testarten) des Tests bei unterschiedlichen Ausführungsbedingungen umfasst, wobei diese Ausführungsbedingungen in Testkonfigurationen festgelegt sind. Die Erfindung betrifft weiterhin ein entsprechendes Computerprogrammprodukt und ein entsprechendes Computerbasiertes Steuerungssystem zur Steuerung von entsprechenden Tests.

Aus dem Stand der Technik bekannt sind Verfahren und Vorrichtungen zum Testen komplexer technischer Systeme, sowie Verfahren zur Bewertung des Testfortschrittes. Die veröffentlichte US-Patentenanmeldung US2011/0145653A1 beschreibt ein Verfahren zum Testen von Software zur Steuerung komplexer technischer Systeme (z.B. automotiver Steuergeräte). Das Verfahren verwendet aus Nutzungs-Szenarien abgeleitete Nutzungsmodelle zur Bestimmung der auszuführenden Testfälle. Des Weiteren beschreibt die US-Patentanmeldung US2003/0046613A1 ein Verfahren zur automatischen Erzeugung von Testfällen in Abhängigkeit der Testabdeckung (engl. "test coverage"), welche eine Metrik zur Bestimmung des Testfortschrittes darstellt.

Im Rahmen eines Entwicklungsprozesses für mechatronische Systeme wie etwa Steuergeräte und deren Software entsteht eine Vielzahl von Daten. Neben den Testfällen werden bei jeder Testausführung auch Testergebnisse produziert. Die Aufgabe der Verwaltung der Testfälle besteht bereits länger. Durch aktuelle Entwicklungen im Bereich der Standardisierung und Zertifizierung entstehen Normen, die die Verwaltung der Testergebnisse zum Zwecke des Testnachweises stärker in den Vordergrund rücken.

Zum "Flaschenhals" in diesem Prozess wird in zunehmendem Maße die Testdurchführung. Diese ist durch die komplexe Testumgebung am Hardware-in-the-loop-Simulator (HIL) und durch die Vielzahl an Tests sehr zeitaufwändig. Durch die wachsende Anzahl an Kombinationsmöglichkeiten (Varianten) für das Endprodukt (zum Beispiel Fahrzeug) in aktuellen Entwicklungsprojekten, wird es de fakto immer schwerer, alle Testfälle mit jeder Umgebungskonstellation (Variantenkonfiguration) durchzuführen. Ferner stellt sich die Frage nach einer "intelligenten" Auswahl der auszuführenden Testfälle und der Kombinationsmöglichkeiten für die Umgebungskonstellation.

Aufgrund der enormen Anzahl an Testfällen ist eine Ausführung jedes Testfalls durch den Hersteller bereits schwierig. Will man nun zusätzlich alle Kombinationen der Testumgebung testen, entsteht ein enormer finanzieller und zeitlicher Aufwand. Vor allem der zeitliche Aspekt führt oft dazu, dass verantwortliche Testmanager auf Basis ihrer Erfahrung einzelne Kombinationen für die Tests auswählen. Dabei auftretende "Lücken" werden zwangsläufig in Kauf genommen. Es fehlt hier an einem geeigneten Überblick über die durchgeführten Tests in Abhängigkeit zu den Umgebungs-Kostellationen. Ziel ist in diesem Fall die Kenntnis über die "Lücken". Diese wird für eine Aussage über Testfortschritt und damit über den Reifegrad der Software genutzt. Ferner fehlt ein geeignetes Mittel, um effektive Umgebungskonstellationen und -kombinationen zu ermitteln.

Vor der Durchführung eines Tests müssen also eine Vielzahl von Festlegung getroffen werden, um den Test eindeutig und damit auch reproduzierbar festzulegen. Dazu zählen die genaue Bestimmung des zu testenden Systems (SUT: System under Test) durch Hard- und Software. Es muss festgelegt werden ob nur einzelne Komponenten oder ein zusammenhängendes System getestet werden sollen und dafür die entsprechende Hardware und deren Verschaltung, sowie die Softwareversion(en) und ihre konkrete Parametrierung bestimmt werden. Außerdem ist eine eindeutige Bestimmung der Testumgebung nötig. Dies beginnt mit der Ausführungsumgebung des Testes. Hierbei können Offline-Simulationen, Hardware-in-the-Loop-Tests (HIL) oder auch ein Tests unter "realen" Bedingungen (z.B. im Fahrzeug) durchgeführt werden. Weiter ist festzulegen ob der Tests manuell oder automatisiert ausgeführt werden soll und die entsprechenden Anweisungen (z.B. Ablaufpläne oder Testimplementierungen) festgelegt werden. Auch bei diesen Anweisungen können verschieden Versionen oder Ausführungen für den gleichen zu testenden Sachverhalt vorliegen.

Viele dieser für einen Test nötigen Festlegungen stehen in sich bedingenden oder einander ausschließenden Abhängigkeiten. So ist zum Beispiel für einen HIL-Test ein konkretes physikalisch vorliegendes Steuergerät (Hardware) nötig, während für eine Simulation am PC schon der Algorithmus (reine Software) ausreichend sein kann. Entsprechend kann ein HIL-Systemtest automatisiert durchgeführt werden, während ein Test im realen Fahrzeug eine manuelle Durchführung erfordert.

Ein Teil dieser vollständigen Konfiguration und ihrer internen Abhängigkeiten liegt in Form einer Variantenmodells vor. Hierbei werden, (häufig) vom Produkt ausgehende, Variantenentscheidungen als Variationspunkte genommen. Zusätzlich sind, wie oben beschrieben, weitere Informationen für einen Test nötig, die für gewöhnlich nicht in einem Variantenmodell abgebildet werden. Alle diese Informationen über mögliche Konfigurationen und ihre Abhängigkeiten können manuell oder mit einfachen Mitteln, wie z.B. Tabellen, nicht mehr effektiv verwaltet werden. Daher werden diese häufig in Datenbanken gespeichert und über speziell für das Management von Tests ausgelegte bearbeitet und ausgewertet.

Aus dieser unübersichtlichen Menge von "vollständigen" und erlaubten Testkonfigurationen ist es manuell nicht mehr möglich anhand objektiver Kriterien den bzw. die Tests und Testkonfigurationen auszuwählen, welche den größten möglichen Fortschritt beim Testen bringen. Daher werden Entscheidungen über den oder die nächsten auszuführenden Testkonfigurationen häufig in einzelnen Schritten getroffen. So wird z.B. zunächst das SUT, anschließend die Testumgebung, weiter die Ausführungsmethode (manuell oder automatisch) und zum Schluss die Variantenkonfiguration (evtl. in mehreren Schritten) festgelegt. Durch jeden dieser Schritte schränkt man die Auswahl der möglichen Testkonfigurationen durch Filterung weiter ein. Damit werden Entscheidungen bezüglich der auszuwählenden Testkonfigurationen immer nur auf einer Untermenge aller möglichen Testkonfigurationen getroffen und nie alle Testkonfigurationen verglichen.

Ein Problem besteht nun darin Testfortschritt und Ressourcen in jeweils einheitlicher Form darzustellen und zueinander in Beziehung zu setzen.

Der Erfindung liegt die Aufgabe zugrunde, Maßnahmen anzugeben, mittels derer ein möglichst großer fortlaufender Fortschritt beim Testen erreicht wird.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Bei dem erfindungsgemäßen Verfahren zum Testen des mechatronischen Systems mittels der mit dem mechatronischen System wechselwirkenden Testumgebung, die unterschiedliche Testfälle (Testarten) des Tests bei unterschiedlichen Ausführungsbedingungen ermöglicht ist vorgesehen, dass die Ausführungsbedingungen in Testkonfigurationen festgelegt sind und wobei jeder Kombination von Testfall und Testkonfiguration ein Teststatuswert aus einer Gruppe vordefinierter Teststatuswerte gemäß einer Bewertung der Funktion des mechatronischen Systems bei dem entsprechenden Test zugeordnet wird. Dabei wird zur weiteren Planung, Durchführung und/oder Bewertung der Testreihe mindestens einmal (i) eine relative Testabdeckung mindestens eines der Statuswerte in der sich ergebenden Testfälle-Konfigurationen-Matrix bestimmt und/oder (ii) ein relatives Steigerungspotential der Testabdeckung mindestens eines der Statuswerte bezüglich einer Testfall und/oder bezüglich einer Konfiguration bestimmt. Es ergeben sich durch Bestimmung von Testabdeckung und Steigerungspotential nun in vorteilhafter Weise Kriterien für eine systematische Durchführung der Testreihe(n). Erwünschtes Ziel dieses Testverfahrens ist es, den Test mit einer möglichst hohen (relativen) Testabdeckung, also möglichst mit einer relativen Testabdeckung von 1 beziehungsweise 100%, bezüglich der Kombination von Testfällen und Testkonfigurationen abzuschließen.

Zum besseren Verständnis der Begriffe "relative Testabdeckung" und "relatives Steigerungspotential" sowie des Zusammenhangs dieser Begriffe mit den Teststatuswerten in der Testfälle-Konfigurationen-Matrix seien an dieser Stelle ein paar erklärende Beispiele gegeben:

Der Teststatuswert, für den die relative Testabdeckung und/oder das relative Steigerungspotential der Testabdeckung bestimmt werden, ist vorzugsweise ein gewünschter Teststatuswert, also ein Teststatuswert, der einem gewünschten Teststatus des mechatronischen Systems entspricht. Im allereinfachsten Fall gibt es zwei Statuswerte: ein erster Teststatuswert +, der den gewünschten Teststatus "Test erfolgreich" beschreibt und ein zweiter Teststatuswert -/o, der angibt, dass der gewünschte Status beim Test nicht erreicht wurde. In einem etwas differenzierteren Fall ergeben sich drei Teststatuswerte: "Test erfolgreich" = +, "Test nicht erfolgreich" = - und "Test nicht durchgeführt" = o.

Für den zweiten Fall ergeben sich die folgenden konkreten Formeln für die Berechnungsvorschriften von relativer Testabdeckung und relativem Steigerungspotential der Testabdeckung:

- Testabdeckung = $\{\sum(TS=+)\} / \{\sum(TS=+)+ \sum(TS=-)+ \sum(TS=o)\}$;
- Testabdeckung = $\{G1 * \sum(TS=+)\} / \{G1 * \sum(TS=+)+G2* \sum(TS=-)+G3* \sum (TS=o)\}$;
- Steigerungspotential = $\{\sum(TS=- )+ \sum(TS=o)\} / \{\sum(TS=+)+ \sum(TS=-)+ \sum (TS=o)\}$ und
- Steigerungspotential = $\{G2* \sum(TS=-)+G3* \sum(TS=o)\} / \{G1 * \sum(TS=+)+G2* \sum(TS=-)+G3* \sum(TS=o)\}$
  mit TS=Teststatus und Gn=Gewichtung.

Mit Vorteil ist vorgesehen, dass zur Bestimmung der relativen Testabdeckung und/oder des relativen Steigerungspotentials immer nur die Teststatuswerte der letzten durchgeführten Ausführung einer jeden Kombination aus Testfall und Testkonfiguration herangezogen werden. Dies ist insbesondere für iterative Verfahren von Vorteil.

Gemäß einer vorteilhaften Ausgestaltung der Erfindung ist vorgesehen, dass

- eine auf die Bestimmung des relativen Steigerungspotentials der Testabdeckung folgende Testreihe eine Testreihe gemäß eines Testfalls und/oder einer Testkonfiguration ist, bei der beziehungsweise bei denen ein Steigerungspotential bezüglich eines gewünschten Statuswerts +, -, o vorhanden ist und/oder
- der Test des mechatronischen Systems beendet wird, wenn die relative Testabdeckung eines gewünschten Statuswerts +, -, o in der sich ergebenden Testfälle-Konfigurationen-Matrix den Wert 1 (= 100%) oder eine vorgegebenen relative Testabdeckungsschwelle kleiner 1 erreicht hat. Alternativ zur vollständigen Testabdeckung kann eine Testabdeckungsschwelle definiert sein, die eine vordefinierte ausreichende Testabdeckung angibt.

Ergibt sich bezüglich der Testfälle und/oder Testkonfigurationen mehrmals ein Steigerungspotential, so ist bevorzugt vorgesehen, dass die auf die Bestimmung des relativen Steigerungspotentials der Testabdeckung folgende Testreihe eine Testreihe gemäß des Testfalls und/oder der Testkonfiguration ist, bei der/denen ein Steigerungspotential bezüglich des gewünschten Statuswerts +, -, o maximal ist. Durch diese Auswahl soll möglichst schnell eine möglichst hohe Testabdeckung erreicht werden.

Insbesondere sollen nur solche Kombinationen aus Testfällen und Testkonfigurationen berücksichtigt werden, die erlaubt oder überhaupt möglich sind. Bei einer solchen Ausgestaltung des Tests wird ein Teststatus x = Test nicht erlaubt oder Test nicht ausführbar überflüssig.

Gemäß einer weiteren vorteilhaften Ausgestaltung der Erfindung wird die mit dem mechatronischen System wechselwirkende Testumgebung von einem Simulator, insbesondere einem Hardware-in-the-loop-Simulator, simuliert. Derartige Simulatoren sind aus dem Stand der Technik bekannt. Sie können eine Testumgebung schaffen, bei der die unterschiedlichen Testfälle des Tests bei unterschiedlichen Ausführungsbedingungen realisiert werden kann.

Bei dem erfindungsgemäßen Verfahren ist vorgesehen, dass die Testkonfigurationen die Ausführungsbedingungen über mindestens einen physikalisch-technischen Parameter (T1, T2, T3) festgelegt werden.

Insbesondere ist dabei vorgesehen, dass die Parameterart des Parameters aus der folgenden Liste von Parameterarten ist: Weg s, Geschwindigkeit v, Beschleunigung g, Zeitspanne t, Kraft F, Druck p, Drehmoment N, Spannung U, Strom I, Leistung P und Temperatur T.

Bei dem erfindungsgemäßen Verfahren ist vorgesehen, dass

- Gewichtungen der Tests, der Parameter, der Testkonfigurationen und/oder der Teststatus vorgegeben sind, wobei die Gewichtung der Tests und Testkonfigurationen als das Verhältnis von Priorität und Aufwand der Tests und Testkonfigurationen vorgegeben sind und
- die Berechnungsvorschriften für die relative Testabdeckung und das relative Steigerungspotential der Testabdeckung zusätzlich von den jeweiligen Gewichtungen abhängig sind.

Das erfindungsgemäße Computerprogrammprodukt ist ausgebildet, um ein vorstehend genanntes Verfahren zum Testen eines realen und/oder virtuellen mechatronischen Automotive-Systems oder eines anderen realen und/oder virtuellen mechatronischen Systems auszuführen.

Bei dem erfindungsgemäßen computerbasierten Steuerungssystem zur Steuerung von Tests eines mechatronischen Automotive-Systems oder eines anderen mechatronischen Systems mittels einer mit dem mechatronischen System wechselwirkenden Testumgebung ist vorgesehen, dass dieses Steuerungssystem zur Durchführung von Tests gemäß dem vorstehend genannten Verfahren geeignet beziehungsweise eingerichtet ist.

Nachfolgend wird die Erfindung unter Bezugnahme auf die anliegenden Zeichnungen anhand einer bevorzugten Ausführungsform näher erläutert.

Es zeigen:

Fig. 1 einen Testaufbau zum Testen eines mechatronischen Systems mittels eines Verfahrens gemäß einer bevorzugten Ausführungsform der Erfindung und

Fig. 2 eine Tabelle die die Zuordnung von Teststatuswerten zu einer Matrix aus Testfälle und deren Konfigurationen für die mit dem in Fig. 1 gezeigten Testaufbau gemachten Tests des mechatronischen Systems.

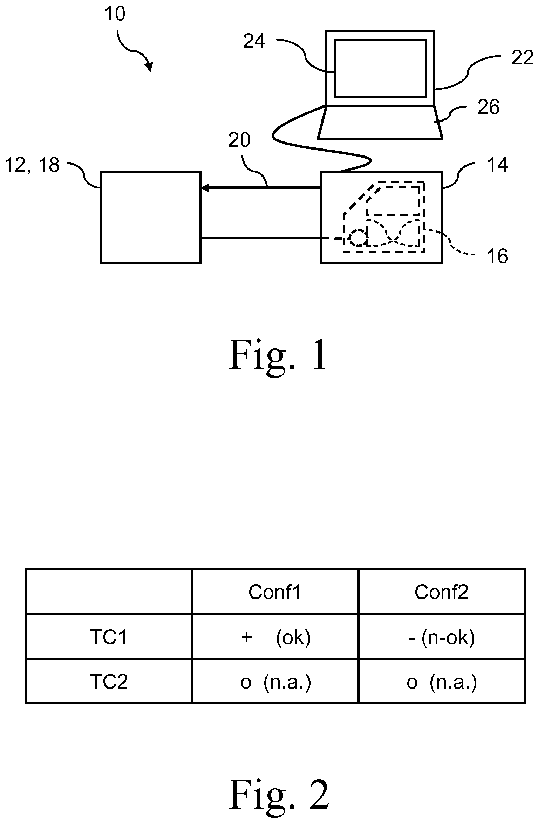

Die Fig. 1 zeigt eine schematische Darstellung ein einfaches Beispiel eines Testaufbaus 10 zum Testen eines mechatronischen Systems ("system under Test" = SUT) 12 bestehend aus der Hardware des Systems, nämlich einem Steuergerät sowie einer (nicht dargestellten) entsprechenden auf dem Steuergerät ausgeführten Software. Die Tests werden an einem einen Simulationsrechner aufweisenden Hardware-in-the-loop-Simulator (HIL) 14 mit Hilfe einer auf dem Simulationsrechner laufenden Testautomatisierungs-Software durchgeführt. Der Simulationsrechner simuliert das Umfeld für das zu testende mechatronische System 12, also dessen Testumgebung 16. Das zu testende mechatronische System 12 ist im gezeigten Beispiel ein Automotive-System 18 mit einem Steuergerät für einen Fensterheber eines Personenkraftwagens (PKWs) oder anderen Fahrzeugs. Mittels des Simulationsrechners 14 sowie der Testautomatisierungs-Software werden dem Steuergerät die Ansteuerungssignale sowie die Reaktionen des Systems Fensterheber-Fenster (Signal 20) simuliert. Die Planung, Durchführung und Bewertung der Tests des mechatronischen Systems erfolgt beispielsweise über einen an den Simulationsrechner 14 angeschlossenen Computer 22 mit Mensch-Maschine-Schnittstellen, wie etwa einem Display 24 und einer Eingabeeinheit 26, wie etwa einer Tastatur, einer Maus, einem Track-Ball, etc.

Grundlage für die hier vorgeschlagene Lösung ist die konsistente Datenbasis der Testfälle und Ergebnisse, teilweise in Relation zum Variantenmodell. Es handelt sich dabei einerseits um Darstellungsmittel, andererseits um Berechnungen und automatische Ableitungen aus diesen Darstellungen / Relationen, deren Ergebnisse dann in den Testprozess zurückfließen. Auf diese Art sind Visualisierungen und Aussagen über den aktuellen Testfortschritt und die Testabdeckung möglich. Ferner können ausgehend von diesen Daten Vorschläge ermittelt werden, welche zukünftigen Testausführungen den größten Einfluss auf die Datenbasis und damit potenziell den größten Testfortschritt bringen könnten.

Der Testfortschritt verschiedener Konfigurationen kann berechnet und dargestellt werden. Hierzu wird erfindungsgemäß die vollständige Datenbasis verwendet und anhand einer vorgegebenen Metrik der mögliche Testfortschritt bestimmt. Durch Festlegen von Prioritäten lässt sich diese Metrik den Bedürfnissen des Testprojektes anpassen.

Zur Bestimmung der allgemein für eine Testkonfiguration nötigen Ressourcen ist es zunächst nötig diese Ressourcen in ein einheitliches Format, zwecks mathematischer Verknüpfung miteinander, zu bringen. Auch hierbei kann, analog zur Priorität, eine abstrakte Größe "Aufwand" jeder Ressource zugewiesen werden.

Priorität und Aufwand bilden so abstrakt Gründe für und gegen eine zeitnahe Testausführung ab. Verwendet man das Verhältnis von Priorität und Aufwand als Gewichtung der Tests und Testkonfigurationen, erhält man eine objektive Grundlage für die Entscheidung welche Tests mit welcher Testkonfiguration wann auszuführen ist.

Es ergibt sich nun die folgende einfache Testplanung zu Tests einer Funktionalität des Steuergerätes 12 mit Software für den elektrischen Fensterheber zum Öffnen und Schließen eines Fensters des PKWs.

Im Beispiel werden der Einfachheit halber nur zwei Testfälle TC1, TC2 ausgewählt:

1. TC1: Öffnen des Fensters (Signal "schließe Fenster" für T1 Sekunden, Signal "öffne Fenster" für T2 Sekunden, Warte T3 Sekunden, Abfrage "Fenster vollständig geöffnet?")

2. TC2: Schließen des Fensters (Signal "öffne Fenster" für T1 Sekunden, Signal "schließe Fenster" für T2 Sekunden, Warte T3 Sekunden, Abfrage "Fenster vollständig geschlossen?")

Für das Testmanagement sind nicht alle Details der Tests relevant. In diesem Beispiel wird davon ausgegangen, dass nur die Parameter T1, T2 und T3 als Teil der Testkonfiguration (siehe unten) für das Testmanagement relevant sind. Weiterhin werden der Einfachheit halber auch nur zwei Testkonfigurationen werden betrachtet:

1. Conf1: SUT besteht aus ECU mit SW, für die Testausführung wird HIL-Simulator A und eine Testautomatisierungs-Tool B als Ausführungsumgebung verwendet, der Test verwendet den Parametersatz C (T1 =15s, T2=3s, T3=20s)

2. Conf2: SUT besteht aus ECU mit SW, für die Testausführung wird HIL-Simulator A und eine Testautomatisierungs-Tool B als Ausführungsumgebung verwendet, der Test verwendet den Parametersatz D (T1 =15s, T2=2s, T3=20s)

Damit unterscheiden sich die Testkonfigurationen nur in einem der verwendeten Parameter, nämlich Parameter T2. Nichtsdestotrotz ergeben sich damit aber zwei verschiedene Testkonfigurationen Conf1, Conf2.

Jeder Testfall-Testkonfigurations-Kombination wird nun entsprechend dem letzten Testergebnis, falls vorhanden, ein Teststatus zugeordnet. Es ergibt sich für jede Kombination ein Teststatus nach folgender Zuordnung und tabellarische Darstellung:

- Test mit positivem Ergebnis durchgeführt → "+"
- Test mit negativen Ergebnis durchgeführt → "-"
- Test wurde nicht durchgeführt → "o"

Es ergibt sich im Beispiel die Tabelle gemäß Fig.2.

Für die Testabdeckung von Teststatus mit Wert "+" bezogen auf alle Teststatus ergibt sich dann:

$$\text{Testabdeckung} = 1 / (1+1+2) = 1/4 \text{ bzw. } 25\%$$

Für die Steigerungspotentiale ergeben sich entsprechend:

Steigerungspotentiale (Conf1) = 1 / 4 bzw. 25%
Steigerungspotentiale (Conf2) = 2 / 4 bzw. 50%
Steigerungspotentiale (TC1) = 1 / 4 bzw. 25%
Steigerungspotentiale (TC2) = 2 / 4 bzw. 50%

Bezugszeichenliste

| | |
|---|---|
| Testaufbau | 10 |
| Steuergerät | 12 |
| Hardware-in-the-loop-Simulator (HIL) | 14 |
| Testumgebung | 16 |
| Automotive-System | 18 |
| Signal | 20 |
| Computer | 22 |
| Display | 24 |
| Eingabeeinheit | 26 |
| Testfall | TC1, TC2 |
| Testkonfiguration | Conf1, Conf2 |
| Konfigurations-Parametersatz | T1, T2, T3 |
| Teststatuswert | +, -, o |

**Patentansprüche**

1. Computerimplementiertes Verfahren zum Testen eines realen und/oder virtuellen mechatronischen Automotive-Systems (18) oder eines anderen realen und/oder virtuellen mechatronischen Systems (12) durch einen Test mittels einer mit dem realen und/oder virtuellen mechatronischen System (12, 18) wechselwirkenden Testumgebung (16), wobei das Verfahren eine Testreihe mit unterschiedlichen Testfällen (TC1, TC2) des Tests bei unterschiedlichen Ausführungsbedingungen umfasst und wobei diese Ausführungsbedingungen in Testkonfigurationen (Conf1, Conf2) festgelegt sind, wobei jeder Kombination von Testfall (TC1, TC2) und Testkonfiguration (Conf1, Conf2) ein Teststatuswert aus einer Gruppe vordefinierter Teststatuswerte (+, -, o) gemäß einer Bewertung der Funktion des mechatronischen Systems (12, 18) bei dem entsprechenden Test zugeordnet wird, wobei zur weiteren Planung, Durchführung und/oder Bewertung der Testreihe mindestens einmal

   - eine relative Testabdeckung mindestens eines der Statuswerte (+, -, o) in der sich ergebenden Testfälle-Konfigurationen-Matrix (TC1, TC2; Conf1, Conf2) und/oder
   - ein relatives Steigerungspotential der Testabdeckung mindestens eines der Statuswerte (+, -, o) bezüglich eines Testfalls (TC1, TC2) und/oder bezüglich einer Konfiguration (Conf1, Conf2)

   bestimmt wird,
   wobei die Testkonfigurationen (Conf1, Conf2) die Ausführungsbedingungen über mindestens einen physikalisch-technischen Parameter (T1, T2, T3) festlegen,
   **dadurch gekennzeichnet dass**
   Gewichtungen der Tests, der Parameter, der Testkonfigurationen und/oder der Teststatus vorgegeben sind,
   wobei die Gewichtung der Tests und Testkonfigurationen als das Verhältnis von Priorität und Aufwand der Tests und Testkonfigurationen vorgegeben sind und
   die Berechnungsvorschriften für die relative Testabdeckung und das relative Steigerungspotential der Testabdeckung zusätzlich von den jeweiligen Gewichtungen abhängig sind.

2. Verfahren nach Anspruch 1, wobei zur Bestimmung der relativen Testabdeckung und/oder des relativen Steigerungspotentials immer nur die Teststatuswerte (+, -, o) der letzten vorliegenden Ausführung einer jeden Kombination aus Testfall und Testkonfiguration (TC1, TC2; Conf1, Conf2) herangezogen werden.

3. Verfahren nach Anspruch 1 oder 2, wobei

   - eine auf die Bestimmung des relativen Steigerungspotentials der Testabdeckung folgende Testreihe eine Testreihe gemäß eines Testfalls und/oder einer Testkonfiguration ist, bei der/denen ein Steigerungspotential bezüglich eines gewünschten Statuswerts (+, -, o) vorhanden ist und/oder
   - der Test des mechatronischen Systems (12) beendet wird, wenn die relative Testabdeckung eines gewünschten Statuswerts (+, -, o) in der sich ergebenden Testfälle-Konfigurationen-Matrix (TC1, TC2; Conf1, Conf2) den Wert 1 oder eine vorgegebenen relative Testabdeckungsschwelle kleiner 1 erreicht hat.

4.  Verfahren nach Anspruch 3, wobei die auf die Bestimmung des relativen Steigerungspotentials der Testabdeckung folgende Testreihe eine Testreihe gemäß des Testfalls und/oder der Testkonfiguration ist, bei der/denen ein Steigerungspotential bezüglich des gewünschten Statuswerts (+, -, o) maximal ist.

5.  Verfahren nach einem der Ansprüche 1 bis 4, wobei nur solche Kombinationen aus Testfall und Testkonfiguration (TC1, TC2; Conf1, Conf2) berücksichtigt werden, die erlaubt oder überhaupt möglich sind.

6.  Verfahren nach einem der Ansprüche 1 bis 5, wobei die mit dem mechatronischen System (12, 18) wechselwirkende Testumgebung (16) von einem Simulator (14), insbesondere einem Hardware-in-the-loop-Simulator, simuliert wird.

7.  Verfahren nach einem der Ansprüche 1 bis 6, wobei die Parameterart des Parameters aus der folgenden Liste von Parameterarten ist: Weg, Geschwindigkeit, Beschleunigung, Zeitspanne, Kraft, Druck, Drehmoment, Spannung, Strom, Leistung und Temperatur.

8.  Verfahren nach einem der vorhergehenden Ansprüche, wobei das mechatronische System (12, 18) neben Hardware auch Software umfasst.

9.  Computerprogrammprodukt, das ausgebildet ist, um ein Verfahren zum Testen eines realen und/oder virtuellen mechatronischen Automotive-Systems (18) oder eines anderen realen und/oder virtuellen mechatronischen Systems (12), nach einem der Ansprüche 1 bis 8 auszuführen.

10. Computerbasiertes Steuerungssystem (14, 22) zur Steuerung vonTests eines mechatronischen Automotive-Systems (18) oder eines anderen mechatronischen Systems (12) mittels einer mit dem mechatronischen System (12) wechselwirkenden Testumgebung (16) gemäß einem Verfahren nach einem der Ansprüche 1 bis 8.

**Claims**

1.  A computer-implemented method for testing a real and/or virtual mechatronic automotive system (18) or another real and/or virtual mechatronic system (12) in a test by means of a test environment (16) interacting with the real and/or virtual mechatronic system (12, 18), the method comprising a test series having different test cases (TC1, TC2) of the test under different conditions of execution, and said conditions of execution being defined in test configurations (Conf1, Conf2), each combination of test case (TC1, TC2) and test configuration (Conf1, Conf2) being associated with one test status value for the corresponding test from a group of predefined test status values (+, -, 0) according to an evaluation of the function of the mechatronic system (12, 18),

    - a relative test coverage of at least one of the status values (+, - , 0) in the resulting test case-configuration matrix (TC1, TC2; Conf1, Conf2) and/or
    - a relative potential increase in test coverage of at least one of the status values (+, - , 0) with respect to a test case (TC1, TC2) and/or with respect to a configuration (Conf1, Conf2)

    being determined at least once for further planning, execution, and/or evaluation of the test series, the test configurations (Conf1, Conf2) define the conditions of execution by means of at least one technical physical parameter (T1, T2, T3),
    **characterized in that**
    weightings of the tests, the parameters, the test configurations, and/or the test status are specified, wherein the weighting of the tests and test configurations are specified as the ratio of priority and effort of the tests and test configurations and
    the calculation rules for the relative test coverage and the relative potential increase in test coverage are also dependent on the corresponding weightings.

2.  The method according to claim 1, wherein only the test status values (+, -, 0) of the latest execution of each combination of test case and test configuration (TC1, TC2; Conf1, Conf2) are always used for determining the relative test coverage and/or the relative potential increase.

3.  The method according to claim 1 or 2, wherein

    - a test series following the determining of the relative potential increase of the test coverage is a test series according to a test case and/or a test configuration wherein a potential increase is present relative to a desired status value (+, -, 0), and/or
- the test of the mechatronic system (12) is terminated when the relative test coverage of a desired status value (+, -, 0) in the resulting test case-configuration matrix (TC1, TC2; Conf1, Conf2) has reached the value 1 or a relative test coverage threshold defined as less than 1.

4. The method according to claim 3, wherein the test series following the determining of the relative potential increase of the test coverage is a test series according to the test case and/or the test configuration wherein a potential increase is maximal relative to the desired status value (+, -, 0).

5. The method according to any one of the claims 1 through 4, wherein only such combinations of test case and test configuration (TC1, TC2; Conf1, Conf2) are considered that are allowed or possible at all.

6. The method according to any one of the claims 1 through 5, wherein the test environment (16) interacting with the mechatronic system (12, 16) is simulated by a simulator (14), particularly a hardware-in-the-loop simulator.

7. The method according to any one of the claims 1 through 6, wherein the parameter type of the parameter is one of the following list of parameter types: distance, velocity, acceleration, elapsed time, force, pressure, torque, voltage, current, power, and temperature.

8. The method according to any one of the preceding claims, wherein the mechatronic system (12, 18) comprises software as well as hardware.

9. A computer program product implemented for executing a method for testing a real and/or virtual mechatronic automotive system (18) or another real and/or virtual mechatronic system (12) according to any one of the claims 1 through 8.

10. A computer-based control system (14, 22) for controlling tests of a mechatronic automotive system (18) or of another mechatronic system (12) by means of a test environment (16) interacting with the mechatronic system (12) according to a method according to any one of the claims 1 through 8.


**Revendications**

1. Procédé mis en œuvre sur ordinateur pour tester un système automobile (18) mécatronique réel et/ou virtuel ou un autre système mécatronique (12) réel et/ou virtuel au moyen d'un essai à l'aide d'un environnement d'essai (16) interagissant avec le système mécatronique (12, 18) réel et/ou virtuel, le procédé comprenant une série d'essais avec différents cas d'essai (TC1, TC2) de l'essai dans différentes conditions d'exécution et dans lequel ces conditions d'exécution sont déterminées dans des configurations d'essai (Conf1, Conf2), dans lequel une valeur d'état d'essai est attribuée à chaque combinaison de cas d'essai (TC1, TC2) et de configuration d'essai (Conf1, Conf2) à partir d'un groupe de valeurs d'état d'essai prédéfinies (+, -, 0) selon une évaluation du fonctionnement du système mécatronique (12, 18) dans l'essai correspondant,
dans lequel est déterminé au moins une fois, pour la planification, l'exécution et/ou l'évaluation ultérieures de la série d'essais,

- une couverture d'essai relative d'au moins l'une des valeurs d'état (+, -, 0) dans la matrice de configurations de cas d'essai (TC1, TC2 ; Conf1, Conf2) résultante et/ou
- un potentiel d'accroissement relatif de la couverture d'essai d'au moins l'une des valeurs d'état (+, -, 0) par rapport à un cas d'essai (TC1, TC2) et/ou par rapport à une configuration (Conf1, Conf2),

dans lequel les configurations d'essai (Conf1, Conf2) détermines les conditions d'exécution au moyen d'au moins un paramètre physico-technique (T1, T2, T3),
**caractérisé en ce que**
des pondérations des essais, des paramètres, des configurations d'essai et/ou des états d'essai sont déterminées à l'avance,
la pondération des essais et des configurations d'essai est déterminée à l'avance en tant que le rapport entre la priorité et l'effort des essais et des configurations d'essai et
les règles de calcul prescrites pour la couverture d'essai relative et le potentiel d'accroissement relatif de la couverture d'essai dépendent additionnellement des pondérations respectives.

2. Procédé selon la revendication 1, dans lequel seules les valeurs d'état d'essai (+, -, 0) de la dernière exécution disponible de chaque combinaison de cas d'essai et de configuration d'essai (TC1, TC2 ; Conf1, Conf2) sont utilisées pour déterminer la couverture d'essai relative et/ou le potentiel d'accroissement relatif.

3. Procédé selon la revendication 1 ou 2, dans lequel

   - une série d'essais suivant la détermination du potentiel d'accroissement relatif de la couverture d'essai est une série d'essais selon un cas d'essai et/ou une configuration d'essai, dans lequel/laquelle il existe un potentiel d'accroissement par rapport à une valeur d'état (+, -, 0) souhaitée et/ou
   - l'essai du système mécatronique (12) est terminé lorsque la couverture d'essai relative d'une valeur d'état (+, -, 0) souhaitée dans la matrice de configurations de cas d'essai (TC1, TC2 ; Conf1, Conf2) résultante a atteint la valeur 1 ou un seuil de couverture d'essai relatif inférieur à 1 déterminé à l'avance.

4. Procédé selon la revendication 3, dans lequel la série d'essais suivant la détermination du potentiel d'accroissement relatif de la couverture d'essai est une série d'essais selon le cas d'essai et/ou la configuration d'essai, dans lequel/laquelle un potentiel d'accroissement par rapport à la valeur d'état (+, -, 0) souhaitée est maximal.

5. Procédé selon l'une quelconque des revendications 1 à 4, dans lequel ne sont prises en considération que les combinaisons de cas d'essai et de configuration d'essai (TC1, TC2 ; Conf1, Conf2) qui sont autorisées ou possibles.

6. Procédé selon l'une quelconque des revendications 1 à 5, dans lequel l'environnement d'essai (16) interagissant avec le système mécatronique (12, 18) est simulé par un simulateur (14), en particulier un simulateur « matériel-dans-la-boucle ».

7. Procédé selon l'une quelconque des revendications 1 à 6, dans lequel le type de paramètre du paramètre est issu de la liste de types de paramètre suivante : distance, vitesse, accélération, durée, force, pression, couple, tension, courant, puissance et température.

8. Procédé selon l'une quelconque des revendications, dans lequel le système mécatronique (12, 18) comprend, en plus du matériel, un logiciel.

9. Produit de programme informatique configuré pour exécuter un procédé pour tester un système automobile (18) mécatronique réel et/ou virtuel ou un autre système mécatronique (12) réel et/ou virtuel selon l'une quelconque des revendications 1 à 8.

10. Système de commande (14, 22) basé sur ordinateur pour commander des essais d'un système automobile (18) mécatronique ou d'un autre système mécatronique (12) au moyen d'un environnement d'essai (16) interagissant avec le système mécatronique (12), selon un procédé selon l'une quelconque des revendications 1 à 8.

## Fig. 1

|     | Conf1 | Conf2 |
|-----|-------|-------|
| TC1 | +   (ok) | - (n-ok) |
| TC2 | o (n.a.) | o (n.a.) |

## Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110145653 A1
- US 20030046613 A1